# EUROPEAN PATENT APPLICATION

(11) **EP 4 431 579 A1**
(43) Date of publication of application: **18.09.2024**
(21) Application number: 22909851.2
(22) Date of filing: 14.12.2022
(51) Int. Cl.: C09J 133/08, C08F 220/12, C08F 220/40, C09J 7/30, C09J 7/10, C09J 7/00, G02F 1/1335, B32B 7/00

(54) **ADHESIVE FILM AND PREPARATION METHOD THEREFOR, COMPOSITE COMPONENT, AND ELECTRONIC DEVICE**

(30) Priority: 23.12.2021 CN 202111592050
(71) Applicant: Huawei Technologies Co., Ltd., Shenzhen, Guangdong 518129 (CN)
(72) Inventor: XU, Fuguo, Shenzhen, Guangdong 518129 (CN); LI, Weilin, Shenzhen, Guangdong 518129 (CN); WANG, Jie, Shenzhen, Guangdong 518129 (CN); LI, Min, Shenzhen, Guangdong 518129 (CN)
(74) Representative: Pfenning, Meinig & Partner mbB
(86) International application number: PCT/CN2022/139133
(87) International publication number: WO 2023/116537

(57) **Abstract**

This application provides an adhesive film and a preparation method thereof, a composite assembly, and an electronic device. The adhesive film is prepared through a cross-linking reaction of a prepolymer. The prepolymer includes an alkyl acrylate soft monomer and an acrylate polar monomer. A mass fraction of the alkyl acrylate soft monomer in the prepolymer is greater than or equal to 60 wt%. A mass fraction of the acrylate polar monomer in the prepolymer is less than 30 wt%. The adhesive film provided in this application has an excellent low modulus at a low temperature and a high creep recovery rate, and can be used to improve a service life of a foldable electronic device in repeated folding processes.

## Description

### TECHNICAL FIELD

This application relates to the field of optically clear adhesives, and specifically, to an adhesive film and a preparation method thereof, a composite assembly, and an electronic device.

### BACKGROUND

Currently, above a foldable organic light-emitting diode (Organic Light-Emitting Diode, OLED) display, a plurality of layers of optical film materials such as a polarizer and a transparent polyimide cover film need to be attached to implement functions, for example, prevent reflection of ambient light and protect a screen. Below the screen, a support film and a metal support layer need to be attached to support the screen and avoid defective display caused by an excessively large deformation amount when the screen is pressed. Various different film materials are bonded together by using an optically clear adhesive (Optically Clear Adhesive, OCA).

The optically clear adhesive is a type of viscoelastic body, and has an adhesion strength and a viscoelastic property at a room temperature. An optically clear adhesive used for a common 2D or 3D display module has a relatively large adhesion strength, and can securely bond upper and lower to-be-bonded interfaces. In a bonding process of a foldable display module, film materials need to be bonded together by using a highly adhesive OCA at both the upper and lower to-be-bonded interfaces.

However, in a bending process, upper and lower film materials may be dislocated relative to each other, and a dislocation amount gradually increases with a bending radius and a distance from a middle layer. In the existing commonly-used foldable display module, a dislocation amount of upper and lower film layers may reach three or more times of a thickness of the optically clear adhesive, and the optically clear adhesive OCA needs to have a relatively high creep recovery rate.

Currently, because of a large adhesion strength and a relatively low creep recovery rate, the optically clear adhesive used for bonding of the common 2D or 3D display module cannot meet a use requirement of the foldable display module. In addition, in the bending process of the foldable display module, because the common OCA has a large cohesion force, the upper and lower film layers are securely bonded and cannot be dislocated. As a result, the foldable display module is prone to damage.

### SUMMARY

In view of this, this application provides an adhesive film and a preparation method thereof, a composite assembly, and an electronic device, where the adhesive film has features of flexibility, a low modulus at a low temperature, and an excellent creep recovery rate, to improve a service life of a foldable electronic device.

According to a first aspect, this application provides an adhesive film. The adhesive film is prepared through a cross-linking reaction of a prepolymer. The prepolymer includes an alkyl acrylate soft monomer and an acrylate polar monomer. A mass fraction of the alkyl acrylate soft monomer in the prepolymer is greater than or equal to 60 wt%. A mass fraction of the acrylate polar monomer in the prepolymer is less than 30 wt%.

In the foregoing solution, a mass ratio of the alkyl acrylate soft monomer to the acrylate polar monomer is adjusted, so that the adhesive film can have better wetting effect, to improve an interface adhesion strength of the adhesive film. In this way, the adhesive film has an excellent low modulus at a low temperature and a high creep recovery rate. Therefore, in a foldable electronic device using the adhesive film, the adhesive film can implement creep recovery with dislocation of film materials in repeated folding processes, to avoid a case in which film materials cannot be dislocated due to an excessively large adhesion strength of the adhesive film, thereby improving a service life of the foldable electronic device.

In some implementations, the prepolymer includes an alkyl acrylate soft monomer shown in Formula (I):

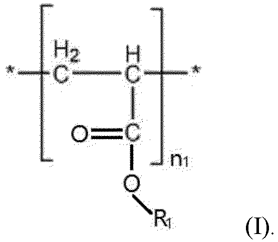

Herein, R₁ is independently selected from substituted or unsubstituted C1-C20 alkyl groups, and n₁ is an integer greater than 0.

Specifically, the alkyl acrylate soft monomer may be at least one of 2-ethylhexyl (meth)acrylate (2-EHA for short), (methyl) methacrylate, ethyl (meth)acrylate, n-propyl (meth)acrylate, isopropyl (meth)acrylate, butyl (meth)acrylate (BA for short), isobutyl (meth)acrylate, n-pentyl (meth)acrylate, hexyl (meth)acrylate, n-octyl (meth)acrylate, 2-ethylhexyl (meth)acrylate, n-nonyl (meth)acrylate, iso-nonyl (meth)acrylate, n-decyl (meth)acrylate, iso-decyl (meth)acrylate, dodecyl (meth)acrylate, 2-ethylhexyl (meth)acrylate, cetyl (meth)acrylate, and octadecyl (meth)acrylate.

In some implementations, the prepolymer includes an acrylate polar monomer shown in Formula (II) and/or an acrylate polar monomer shown in Formula (III): 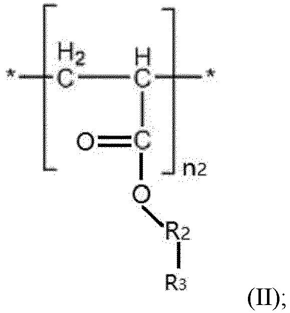 and

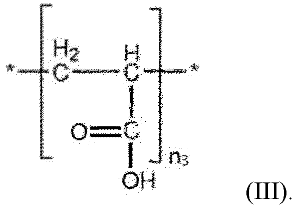

Herein, R₂ is independently selected from substituted or unsubstituted C1-C10 alkyl groups, R₃ is selected from at least one of a hydroxyl group, a carboxyl group, an epoxy group, and an amino group, and n₂ and n₃ are integers greater than 0.

Specifically, the acrylate polar monomer may be any one of an acrylic acid (AA for short), hydroxybutyl acrylate (4HBA for short), hydroxyethyl acrylate (2HEA for short), 2-hydroxypropyl acrylate (HPA for short), hydroxyethyl methacrylate (HEMA for short), and hydroxypropyl methacrylate (HPMA for short). Certainly, the acrylate polar monomer may be alternatively another monomer having a structure shown in Formula (II). This is not limited herein.

In some implementations, the mass fraction of the alkyl acrylate soft monomer in the prepolymer ranges from 60 wt% to 85 wt%, and the mass fraction of the acrylate polar monomer in the prepolymer ranges from 10 wt% to 25 wt%.

In some implementations, the prepolymer includes two types of alkyl acrylate soft monomers. One type of alkyl acrylate soft monomer is selected from butyl acrylate. A mass fraction of the butyl acrylate in the prepolymer ranges from 5 wt% to 20 wt%.

In some implementations, a weight-average molecular weight of the prepolymer is greater than or equal to 600000 Da.

According to a second aspect, this application provides a preparation method of an adhesive film. The method includes:
under protection of an inert gas, mixing an alkyl acrylate soft monomer, an acrylate polar monomer, and a solvent, adding a thermal initiator, and performing heating for a polymerization reaction to obtain a prepolymer, where a mass fraction of the alkyl acrylate soft monomer in the prepolymer is greater than or equal to 60 wt%, and a mass fraction of the acrylate polar monomer in the prepolymer is less than 30 wt%; and
performing coating by using a mixture of the prepolymer and a cross-linking agent to form an adhesive coating, and performing heating for a cross-linking reaction to obtain an adhesive film.

In the foregoing solution, a mass ratio of the alkyl acrylate soft monomer to the acrylate polar monomer is adjusted, so that the adhesive film can have better wetting effect, to improve an interface adhesion strength of the adhesive film. In this way, the adhesive film has an excellent low modulus at a low temperature, and a high creep recovery rate. In addition, the adhesive film is formed by using a thermal curing process. This process is very stable and is simple to operate. In this way, the preparation costs can be effectively reduced.

In some implementations, a weight-average molecular weight of the prepolymer is greater than or equal to 600000 Da.

In some implementations, the prepolymer includes an alkyl acrylate soft monomer shown in Formula (I):

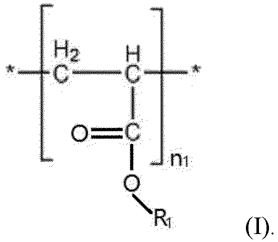

Herein, R₁ is independently selected from substituted or unsubstituted C1-C20 alkyl groups, and n₁ is an integer greater than 0.

In some implementations, the prepolymer includes an acrylate polar monomer shown in Formula (II) and/or an acrylate polar monomer shown in Formula (III): 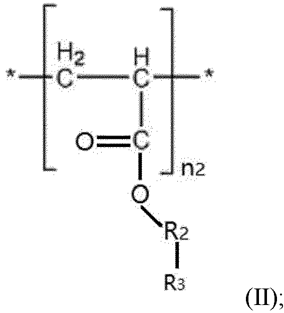 and

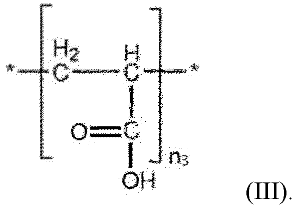

Herein, R₂ is independently selected from substituted or unsubstituted C1-C10 alkyl groups, R₃ is selected from at least one of a hydroxyl group, a carboxyl group, an epoxy group, and an amino group, and n₂ and n₃ are integers greater than 0.

In some implementations, the mass fraction of the alkyl acrylate soft monomer in the prepolymer ranges from 60 wt% to 85 wt%, and the mass fraction of the acrylate polar monomer in the prepolymer ranges from 10 wt% to 25 wt%.

It is assumed that a mass of the prepolymer is 100 wt%. In this case, the mass fraction of the alkyl acrylate soft monomer in the prepolymer is greater than or equal to 60 wt%; and may be specifically 60 wt%, 62 wt%, 65 wt%, 67 wt%, 69 wt%, 72 wt%, 75 wt%, 80 wt%, 85 wt%, or the like, or certainly may be another value within the foregoing range. This is not limited herein.

It is assumed that a mass of the prepolymer is 100 wt%. In this case, the mass fraction of the acrylate polar monomer in the prepolymer is less than 30 wt%; and may be specifically 5 wt%, 10 wt%, 15 wt%, 17 wt%, 19 wt%, 20 wt%, 25 wt%, 28 wt%, 29 wt%, or the like, or certainly may be another value within the foregoing range. This is not limited herein. An excessively large addition amount of the acrylate polar monomer causes an increase of a modulus at a low temperature for the optical adhesive film. This does not facilitate bending under a low temperature condition. An excessively small addition amount of the acrylate polar monomer causes a decrease of an adhesion strength for the adhesive film and a to-be-bonded interface. Preferably, the mass fraction of the acrylate polar monomer in the prepolymer ranges from 10 wt% to 25 wt%.

In some implementations, the prepolymer includes two types of alkyl acrylate soft monomers. One type of alkyl acrylate soft monomer is selected from butyl acrylate. A mass fraction of the butyl acrylate in the prepolymer ranges from 5 wt% to 20 wt%.

The mass fraction may be specifically 5 wt%, 7 wt%, 8 wt%, 10 wt%, 12 wt%, 13 wt%, 14 wt%, 15 wt%, 18 wt%, 20 wt%, or the like, or certainly may be another value within the foregoing range. This is not limited herein. Certainly, the mass fraction may be alternatively another value within the foregoing range. By adding butyl acrylate, wettability of the adhesive film can be adjusted, a creep recovery rate of the adhesive film can be improved, and an interface adhesion strength can be improved.

In some implementations, the thermal initiator is selected from at least one of azobisisobutyronitrile, azobisisoheptonitrile, dimethyl 2,2'-azobis(2-methylpropionate), 2-(1-cyano-1-methylethyl)azocarboxamide, dibenzoyl peroxide, tert-butyl peroxybenzoate, tert-pentyl peroxybenzoate, dicumyl peroxide, and hydrogen peroxide.

In some implementations, a heating temperature of the polymerization reaction ranges from 60°C to 80°C.

In some implementations, a time of the polymerization reaction ranges from 8 h to 20 h.

In some implementations, the inert gas includes at least one of nitrogen, helium, neon, and krypton.

In some implementations, an addition amount of the thermal initiator is 0.02 wt% to 0.5 wt% of a total mass of the monomers.

In some implementations, the cross-linking agent is selected from at least one of toluene diisocyanate, hexamethylene diisocyanate, isophorone diisocyanate, and an epoxy cross-linking agent.

In some implementations, an addition amount of the cross-linking agent is 0.02 wt% to 0.2 wt% of the total mass of the monomers.

According to a third aspect, this application provides a composite assembly. The composite assembly includes a first assembly, a second assembly, and an adhesive film located between the first assembly and the second assembly. The adhesive film includes the adhesive film according to the first aspect or the adhesive film prepared by using the preparation method according to the second aspect.

In some implementations, in a temperature range of 25°C, at a frequency of 1 Hz, a shear storage modulus of the adhesive film is less than or equal to 35 kPa; and may be specifically 35 kPa, 32 kPa, 30 kPa, 28 kPa, 25 kPa, 22 kPa, 20 kPa, or the like, or certainly may be another value within the foregoing range. This is not limited herein. An excessively large shear storage modulus of the adhesive film at a room temperature causes an increase of a bending stress, and causes the composite assembly to be prone to damage during bending.

In some implementations, in a temperature range of -20°C, at a frequency of 1 Hz, a shear storage modulus of the adhesive film is less than or equal to 200 kPa; and may be specifically 200 kPa, 190 kPa, 180 kPa, 170 kPa, 160 kPa, 150 kPa, 140 kPa, 130 kPa, 100 kPa, or the like, or certainly may be another value within the foregoing range. This is not limited herein. An excessively large shear storage modulus of the adhesive film at a low temperature causes the composite assembly to be fractured or peeled at the low temperature during bending.

In some implementations, after a shear stress of 20 kPa is applied for 10 min, recovery is performed for 10 min, and a creep recovery of the adhesive film is greater than or equal to 90%. The creep recovery rate may be specifically 90%, 92%, 94%, 95%, 96%, 97%, 98%, or the like, or certainly may be another value within the foregoing range. This is not limited herein. If the creep recovery rate of the adhesive film is excessively low, the composite assembly is prone to dislocation and damage during repeated folding processes. When the creep recovery rate of the adhesive film prepared in this application is more than 92%, the adhesive film can be quickly recovered after a large quantity of folding tests, to avoid damage between assemblies connected by using the adhesive film. Preferably, the creep recovery of the adhesive film is greater than or equal to 92%.

In some implementations, a glass-transition temperature of the adhesive film is less than or equal to -35°C; and may be specifically -35°C, -37°C, -38°C, -40°C, -42°C, -45°C, -50°C, or the like, or certainly may be another value within the foregoing range. This is not limited herein. An excessively high glass-transition temperature of the adhesive film causes an increase of a modulus at a low temperature for an optical adhesive, and causes the composite assembly to be fractured or peeled at the low temperature during bending.

In some implementations, an adhesion strength between the adhesive film and the first assembly or the second assembly is greater than or equal to 1200 g/inch. The adhesion strength may be specifically 1200 g/inch, 1250 g/inch, 1280 g/inch, 1300 g/inch, 1350 g/inch, 1400 g/inch, 1500 g/inch, or the like, or certainly may be another value within the foregoing range. This is not limited herein. When the adhesion strength is excessively small, the composite assembly is prone to damage and peeling.

In some implementations, a thickness of the adhesive film ranges from 15 µm to 200 µm; and may be specifically 15 µm, 20 µm, 30 µm, 45 µm, 50 µm, 60 µm, 70 µm, 80 µm, 100 µm, or the like, or certainly may be another value within the foregoing range. This is not limited herein.

According to a fourth aspect, this application provides an electronic device. The electronic device includes the composite assembly according to the third aspect.

According to a fifth aspect, this application provides a foldable mobile phone. The foldable mobile phone includes the composite assembly according to the third aspect.

In comparison with the conventional technologies, this application has the following beneficial effects:

For the adhesive film provided in this application, a mass ratio of the alkyl acrylate soft monomer to the acrylate polar monomer is adjusted, so that the adhesive film can have better wetting effect, to improve an interface adhesion strength of the adhesive film. In this way, the adhesive film has an excellent low modulus at a low temperature, and a high creep recovery rate. Therefore, in a foldable electronic device using the adhesive film, the adhesive film can implement creep recovery with dislocation of film materials in repeated folding processes, to avoid a case in which film materials cannot be dislocated due to an excessively large adhesion strength of the adhesive film, thereby improving a service life of the foldable electronic device.

### BRIEF DESCRIPTION OF DRAWINGS

FIG. 1 is a schematic diagram of a structure of a composite assembly according to an embodiment of this application;
FIG. 2a and FIG. 2b are respectively a diagram of rheological test curves and a diagram of a creep recovery rate curve of an adhesive film prepared in Example 2;
FIG. 3a and FIG. 3b are respectively a diagram of rheological test curves and a diagram of a creep recovery rate curve of an adhesive film prepared in Example 5; and
FIG. 4a and FIG. 4b are respectively a diagram of rheological test curves and a diagram of a creep recovery rate curve of an adhesive film prepared in Example 8.

### DESCRIPTION OF EMBODIMENTS

The following descriptions are implementations in embodiments of this application. It should be noted that a person of ordinary skill in the art may make some improvements and polishing without departing from the principle of embodiments of this application and the improvements and polishing shall fall within the protection scope of embodiments of this application.

For simplicity, only some numerical ranges are expressly disclosed in this specification. However, any lower limit may be combined with any upper limit to form a range not expressly recorded; any lower limit may be combined with any other lower limit to form a range not expressly recorded; and any upper limit may be combined with any other upper limit to form a range not expressly recorded. In addition, although not expressly recorded, each point or individual value between endpoints of a range is included in the range. Therefore, each point or individual value may be used as its own lower limit or upper limit to be combined with any other point or individual value or combined with any other lower limit or upper limit to form a range not expressly recorded.

In the descriptions of this specification, it should be noted that, unless otherwise stated, "more than" and "less than" are inclusive of the present number, and "more" in "one or more" means more than two.

The above application content of this application is not intended to describe each disclosed embodiment or each implementation in this application. The following descriptions illustrate example implementations in detail by using examples. Throughout this application, guidance is provided by using a series of embodiments and the embodiments may be used in various combinations. In the examples, enumeration is merely representative but should not be interpreted as exhaustive.

Currently, above a foldable display, a plurality of layers of optical film materials such as a polarizer and a transparent polyimide cover film need to be attached to implement functions, for example, prevent reflection of ambient light and protect a screen. Below the screen, a support film and a metal support layer need to be attached to support the screen and avoid defective display caused by an excessively large deformation amount when the screen is pressed. Various different film materials are bonded together by using an optically clear adhesive (Optically Clear Adhesive, OCA).

The optically clear adhesive is a type of viscoelastic body, and has an adhesion strength and a viscoelastic property at a room temperature. An optically clear adhesive used for a common 2D or 3D display module has a relatively large adhesion strength, and can securely bond upper and lower to-be-bonded interfaces. In a bonding process of a foldable display module, film materials need to be bonded together by using a highly adhesive OCA at both the upper and lower to-be-bonded interfaces.

However, in a bending process, upper and lower film materials may be dislocated relative to each other, and a dislocation amount gradually increases with a bending radius and a distance from a middle layer. In the currently commonly-used foldable display module, a dislocation amount of upper and lower film layers may reach three or more times of a thickness of the optically clear adhesive, and the optically clear adhesive OCA needs to have a relatively high creep recovery rate.

Currently, because of a large adhesion strength and a relatively low creep recovery rate, the optically clear adhesive used for bonding of the common 2D or 3D display module cannot meet a use requirement of the foldable display module. In addition, in the bending process of the foldable display module, because the common OCA has a large cohesion force, the upper and lower film layers are securely bonded and cannot be dislocated. As a result, the foldable display module is prone to damage.

Therefore, in this application, an adhesive film that can be used in a foldable display module is developed. The adhesive film is prepared through a cross-linking reaction of a prepolymer. The prepolymer includes an alkyl acrylate soft monomer and an acrylate polar monomer. A mass fraction of the alkyl acrylate soft monomer in the prepolymer is greater than or equal to 60 wt%. A mass fraction of the acrylate polar monomer in the prepolymer is less than 30 wt%.

In the foregoing solution, a mass ratio of the alkyl acrylate soft monomer to the acrylate polar monomer is adjusted, so that the adhesive film can have better wetting effect, to improve an interface adhesion strength of the adhesive film. In this way, the adhesive film has an excellent low modulus at a low temperature, and a high creep recovery rate. Therefore, in a foldable electronic device using the adhesive film, the adhesive film can implement creep recovery with dislocation of film materials in repeated folding processes, to avoid a case in which film materials cannot be dislocated due to an excessively large adhesion strength of the adhesive film, thereby improving a service life of the foldable electronic device.

In a feasible implementation, the prepolymer includes an alkyl acrylate soft monomer shown in Formula (I):

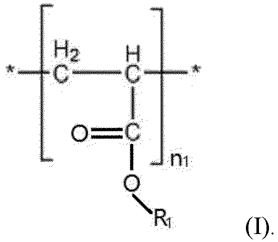

Herein, R₁ is independently selected from substituted or unsubstituted C1-C20 alkyl groups, and n₁ is an integer greater than 0.

Optionally, the C1-C20 alkyl groups may be chain alkyl groups. The chain alkyl group may be a straight-chain alkyl group or a branched alkyl group, or may be a cycloalkyl group. Preferably, the C1-C20 alkyl groups may be chain alkyl groups. More preferably, the C1-C20 alkyl groups may be straight-chain alkyl groups. A preferred lower limit value of a quantity of carbon atoms in the C1-C20 alkyl groups is 1, 2, 3, 4, 6, or 8; and a preferred upper limit value is 10, 12, 14, 15, 18, or 20. Examples of the C1-C20 alkyl groups may be specifically: a methyl group, an ethyl group, an n-propyl group, an isopropyl group, an n-butyl group, an isobutyl group, a sec-butyl group, a tertiary butyl group, an n-amyl group, an iso-amyl group, a neo-amyl group, a hexyl group, 2-methyl-amyl, 3-methyl-amyl, 1,1,2-trimethyl-propyl, 3,3-dimethyl-butyl, a heptyl group, 2-heptyl, 3-heptyl, 2-methyl hexyl, 3-methyl hexyl, an isoheptyl group, an octyl group, a nonyl group, and a decyl group.

In some specific embodiments, the alkyl acrylate soft monomer may be at least one of 2-ethylhexyl (meth)acrylate (2-EHA for short), (methyl) methacrylate, ethyl (meth)acrylate, n-propyl (meth)acrylate, isopropyl (meth)acrylate, butyl (meth)acrylate (BA for short), isobutyl (meth)acrylate, n-pentyl (meth)acrylate, hexyl (meth)acrylate, n-octyl (meth)acrylate, 2-ethylhexyl (meth)acrylate (2-EHMA for short), n-nonyl (meth)acrylate, iso-nonyl (meth)acrylate, n-decyl (meth)acrylate, iso-decyl (meth)acrylate, dodecyl (meth)acrylate, 2-ethylhexyl (meth)acrylate, cetyl (meth)acrylate, and octadecyl (meth)acrylate. Certainly, the alkyl acrylate soft monomer may be alternatively another monomer having the structure shown in Formula (I). This is not limited.

It is assumed that a mass of the prepolymer is 100 wt%. In this case, the mass fraction of the alkyl acrylate soft monomer in the prepolymer is greater than or equal to 60 wt%; and may be specifically 60 wt%, 62 wt%, 65 wt%, 67 wt%, 69 wt%, 72 wt%, 75 wt%, 80 wt%, 85 wt%, 90 wt%, or the like, or certainly may be another value within the foregoing range. This is not limited herein. Preferably, the mass fraction of the alkyl acrylate soft monomer in the prepolymer ranges from 60 wt% to 85 wt%.

In some specific embodiments, the alkyl acrylate soft monomer includes at least butyl acrylate (BA for short). A mass fraction of butyl acrylate in the prepolymer ranges from 5 wt% to 30 wt%; and may be specifically 5 wt%, 15 wt%, 19.5 wt%, 20 wt%, 23 wt%, 29.5 wt%, 30 wt%, or the like, or certainly may be another value within the foregoing range. This is not limited herein. An excessively large quantity of the alkyl acrylate soft monomer indicates an increase of flexibility of the adhesive film and a decrease of a modulus at a low temperature. Preferably, the mass fraction of butyl acrylate in the prepolymer ranges from 5 wt% to 20 wt%.

In a feasible implementation, the prepolymer includes an acrylate polar monomer shown in Formula (II) and/or an acrylate polar monomer shown in Formula (III): 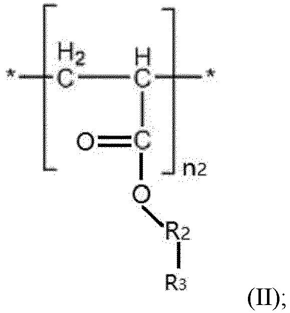 and

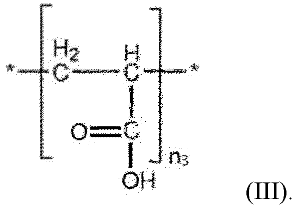

Herein, R₂ is independently selected from substituted or unsubstituted C1-C10 alkyl groups, R₃ is selected from at least one of a hydroxyl group, a carboxyl group, an epoxy group, an amino group, and a sulfo group, and n₂ and n₃ are integers greater than 0.

Optionally, the C1-C10 alkyl groups may be chain alkyl groups. The chain alkyl group may be a straight-chain alkyl group or a branched alkyl group, or may be a cycloalkyl group. Preferably, the C1-C10 alkyl groups may be chain alkyl groups. More preferably, the C1-C10 alkyl groups may be straight-chain alkyl groups. A preferred lower limit value of a quantity of carbon atoms in the C1-C10 alkyl groups is 1, 2, 3, or 4; and a preferred upper limit value is 5, 6, 8, or 10. Examples of the C1-C10 alkyl groups may be specifically: a methyl group, an ethyl group, an n-propyl group, an isopropyl group, an n-butyl group, an isobutyl group, a sec-butyl group, a tertiary butyl group, an n-amyl group, an iso-amyl group, a neo-amyl group, a hexyl group, 2-methyl-amyl, 3-methyl-amyl, 1,1,2-trimethyl-propyl, 3,3-dimethyl-butyl, a heptyl group, 2-heptyl, 3-heptyl, 2-methyl hexyl, 3-methyl hexyl, an isoheptyl group, an octyl group, a nonyl group, and a decyl group.

In some specific embodiments, the acrylate polar monomer may be any one of an acrylic acid (AA for short), hydroxybutyl acrylate (4HBA for short), hydroxyethyl acrylate (2HEA for short), 2-hydroxypropyl acrylate (HPAfor short), hydroxyethyl methacrylate (HEMAfor short), and hydroxypropyl methacrylate (HPMAfor short). Certainly, the acrylate polar monomer may be alternatively another monomer having a structure shown in Formula (II). This is not limited herein.

It is assumed that a mass of the prepolymer is 100 wt%. In this case, the mass fraction of the acrylate polar monomer in the prepolymer is less than 30 wt%; and may be specifically 5 wt%, 10 wt%, 15 wt%, 17 wt%, 19 wt%, 20 wt%, 25 wt%, 28 wt%, 29 wt%, or the like, or certainly may be another value within the foregoing range. This is not limited herein. An excessively large content of the acrylate polar monomer causes an increase of a modulus at a low temperature for the optical adhesive film. This does not facilitate bending under a low temperature condition. An excessively small content of the acrylate polar monomer causes a decrease of an adhesion strength for the adhesive film and a to-be-bonded interface. Preferably, the mass fraction of the acrylate polar monomer in the prepolymer ranges from 10 wt% to 25 wt%.

In some specific embodiments, the weight-average molecular weight of the prepolymer is greater than or equal to 600000 Da; and may be specifically 600000 Da, 800000 Da, 1000000 Da, 1050000 Da, 110000 Da, 1150000 Da, 1180000 Da, 1200000 Da, 1300000 Da, 1400000 Da, or the like, or certainly may be another value within the foregoing range. This is not limited herein. Preferably, the weight-average molecular weight of the prepolymer is greater than or equal to 1000000 Da.

According to a second aspect, this application further provides a preparation method of an adhesive film. The method includes the following steps:
S10: Under protection of an inert gas, mix an alkyl acrylate soft monomer, an acrylate polar monomer, and a solvent, add a thermal initiator, and perform heating for a polymerization reaction to obtain a prepolymer, where a mass fraction of the alkyl acrylate soft monomer in the prepolymer is greater than or equal to 60 wt%, and a mass fraction of the acrylate polar monomer in the prepolymer is less than 30 wt%.
S20: Perform coating by using a mixture of the prepolymer and a cross-linking agent to form an adhesive coating, and perform heating for a cross-linking reaction to obtain an adhesive film.

In the foregoing solution, a mass ratio of the alkyl acrylate soft monomer to the acrylate polar monomer is adjusted, so that the adhesive film can have better wetting effect, to improve an interface adhesion strength of the adhesive film. In this way, the adhesive film has an excellent low modulus at a low temperature, and a high creep recovery rate. In addition, the adhesive film is formed by using a thermal curing process. This process is very stable and is simple to operate. In this way, the preparation costs can be effectively reduced.

It should be noted that, in comparison with a photocuring process, the thermal curing process has lower process control difficulty, and can improve properties of a high creep recovery rate and a large adhesion strength of the adhesive film. In the photocuring process, it is necessary to strictly control uniformity of ultraviolet light, and control humidity and airflow in an ultraviolet light box. It is very difficult to grasp control precision.

This solution is described in detail below.

S10: Under protection of the inert gas, mix the alkyl acrylate soft monomer, the acrylate polar monomer, and the solvent, add the thermal initiator, and perform heating for the polymerization reaction to obtain the prepolymer.

In some embodiments, at least one type of alkyl acrylate soft monomer and at least one acrylate polar monomer may be selected to be mixed with the solvent. The solvent may be any one of ethyl acetate, toluene, and butanone.

An addition amount of the solvent is one to two times of a total mass of all monomers. The monomers are fully mixed and dissolved by using the solvent, to improve uniformity of the polymerization reaction.

The thermal initiator is added to the mixture obtained after the mixing. The thermal initiator is selected from at least one of azobisisobutyronitrile, azobisisoheptonitrile, dimethyl 2,2'-azobis(2-methylpropionate), 2-(1-cyano-1-methylethyl)azocarboxamide, dibenzoyl peroxide, tert-butyl peroxybenzoate, tert-pentyl peroxybenzoate, dicumyl peroxide, and hydrogen peroxide. In a heating process, the monomers are polymerized to obtain the prepolymer. Addition of the thermal initiator helps the polymerization reaction of the monomers fully occur, to improve reaction efficiency. Preferably, the thermal initiator is selected from azobisisobutyronitrile (AIBN for short) whose chemical formula is C₈H₁₂N₄ and that can be dissolved in organic solvents such as methanol, ethanol, ether, butanone, toluene, petroleum ether, and aniline. Nitrogen and organic cyanide containing -(CH₂)₂-C-CN are released through thermal decomposition.

In an optional technical solution of this application, an addition amount of the thermal initiator is 0.02 wt% to 0.5 wt% of the total mass of the monomers; and may be specifically 0.02 wt%, 0.025 wt%, 0.03 wt%, 0.05 wt%, 0.06 wt%, 0.1 wt%, 0.15 wt%, 0.2 wt%, 0.3 wt%, 0.5 wt%, or the like, or certainly may be another value within the foregoing range. This is not limited herein. Excessively large addition of the thermal initiator causes an explosive polymerization reaction, and excessively small addition causes a slow reaction and a low conversion rate. Preferably, the addition amount of the thermal initiator is 0.02 wt% to 0.06 wt% of the total mass of the monomers.

The alkyl acrylate soft monomer is a monomer having the structure shown in Formula (I), and the acrylate polar monomer may be a monomer having the structure shown in Formula (II) and/or Formula (III). This is not described herein again.

It is assumed that a mass of the prepolymer is 100 wt%. In this case, the mass fraction of the alkyl acrylate soft monomer in the prepolymer is greater than or equal to 60 wt%; and may be specifically 60 wt%, 62 wt%, 65 wt%, 67 wt%, 69 wt%, 72 wt%, 75 wt%, 80 wt%, 85 wt%, 90 wt%, or the like, or certainly may be another value within the foregoing range. This is not limited herein. Preferably, the mass fraction of the alkyl acrylate soft monomer in the prepolymer ranges from 60 wt% to 85 wt%.

In some specific embodiments, the alkyl acrylate soft monomer includes at least butyl acrylate (BA for short). A mass fraction of butyl acrylate in the prepolymer ranges from 5 wt% to 30 wt%; and may be specifically 5 wt%, 15 wt%, 19.5 wt%, 20 wt%, 23 wt%, 29.5 wt%, 30 wt%, or the like, or certainly may be another value within the foregoing range. This is not limited herein. An excessively large quantity of the alkyl acrylate soft monomer indicates an increase of flexibility of the adhesive film and a decrease of a modulus at a low temperature. Preferably, the mass fraction of butyl acrylate in the prepolymer ranges from 5 wt% to 20 wt%.

A melting point of butyl acrylate is -69°C. Butyl acrylate has a good interface wetting property, and can be polymerized to form a high polymer with a lower modulus, to help improve adhesion strengths of the adhesive film and various interfaces. In addition, butyl acrylate has a small molecular steric hindrance, to improve a creep recovery speed of the adhesive film, so that the adhesive film has a high creep recovery rate.

It is assumed that a mass of the prepolymer is 100 wt%. In this case, the mass fraction of the acrylate polar monomer in the prepolymer is less than 30 wt%; and may be specifically 5 wt%, 10 wt%, 15 wt%, 17 wt%, 19 wt%, 20 wt%, 25 wt%, 28 wt%, 29 wt%, or the like, or certainly may be another value within the foregoing range. This is not limited herein. An excessively large addition amount of the acrylate polar monomer causes an increase of a modulus at a low temperature for the optical adhesive film. This does not facilitate bending under a low temperature condition. An excessively small addition amount of the acrylate polar monomer causes a decrease of an adhesion strength for the adhesive film and a to-be-bonded interface. Preferably, the mass fraction of the acrylate polar monomer in the prepolymer ranges from 10 wt% to 25 wt%.

In an optional technical solution of this application, a heating temperature of the polymerization reaction ranges from 60°C to 80°C; and may be specifically 60°C, 62°C, 64°C, 65°C, 66°C, 67°C, 69°C, 70°C, 75°C, 80°C, or the like, or certainly may be another value within the foregoing range. This is not limited herein. An excessively high polymerization reaction temperature speeds up the polymerization reaction, resulting in a sharp increase of viscosity of the polymer. In this case, it is difficult to control the reaction. This does not facilitate preparation of an idle adhesive film. An excessively low polymerization reaction temperature slows down the polymerization reaction, reduces a conversion rate, and prolongs a polymerization time. This does not facilitate reduction of the production costs. Preferably, a heating temperature of the polymerization reaction ranges from 65°C to 70°C.

In an optional technical solution of this application, a time of the polymerization reaction ranges from 8 h to 20 h; and may be specifically 8 h, 8.5 h, 9 h, 9.5 h, 10 h, 11 h, 12 h, 15 h, 18 h, 20 h, or the like, or certainly may be another value within the foregoing range. This is not limited herein. The excessively long time of the polymerization reaction, an excessively large molecular weight of the prepolymer, and the excessively high viscosity of the prepolymer do not facilitate a subsequent coating process. The excessively short time of the polymerization reaction, an excessively small molecular weight of the prepolymer, and low viscosity of the solvent indicate higher coating difficulty. Properties of a finished adhesive product do not meet requirements.

In an optional technical solution of this application, the inert gas includes at least one of nitrogen, helium, neon, and krypton.

In an actual preparation process, the alkyl acrylate soft monomer, the acrylate polar monomer, and the solvent are mixed; and then nitrogen or another inert gas is introduced to maximumly discharge oxygen in a mixed solution, thereby avoiding oxygen inhibition effect caused by oxygen. Oxygen inhibition effect may cause a large quantity of oxidizing structures such as a hydroxyl group, a carbonyl group, and a peroxyl group at a surface of the coating of the adhesive film, thereby affecting stability of the coating of the adhesive film and even affecting an adhesive property of the adhesive film after curing.

In a specific embodiment, the alkyl acrylate soft monomer is 2-ethylhexyl acrylate and butyl acrylate, and the acrylate polar monomer is hydroxybutyl acrylate.

S20: Perform coating by using the mixture of the prepolymer and the cross-linking agent to form the adhesive coating, and perform heating for the cross-linking reaction to obtain the adhesive film.

A molecular weight of the prepolymer is more than 600000 Da. Prepolymers are crosslinked by using the cross-linking agent, to form the polymer.

In an optional technical solution of this application, the cross-linking agent includes at least one of toluene isocyanate (toluene isocyanate, TDI for short), hexamethylene diisocyanate (HDI for short), and isophorone diisocyanate (IPDI for short). Due to a highly unsaturated structure of the cross-linking agent, the cross-linking agent has relatively high reactivity. According to an electron resonance theory of an isocyanate group, charge distribution is not uniform due to resonance of -NCO, and a nucleophilic center and an electrophilic center are generated. An electronegative sequence of nitrogen, carbon, and oxygen atoms in the isocyanate group is O > N > C. Therefore, the nitrogen atom and the oxygen atom have higher electron cloud density and present highly electronegative, and easily react with an electrophilic reagent. On the contrary, electron cloud density of the carbon atom is reduced due to effect of highly electronegative atoms at both ends. Therefore, the carbon atom presents strong electropositivity and becomes the electrophilic center. Therefore, the isocyanate group easily reacts with a compound containing a hydrogen atom.

In an actual preparation process, the cross-linking reaction may be accelerated by using a coating film-forming process. After coating film-forming, the adhesive film needs to be put into an incubator with a temperature of 30°C to 60°C for ripening, to accelerate the cross-linking reaction between the cross-linking agent and the prepolymer. A time of the ripening in the cross-linking reaction ranges from 24 h to 120 h; and may be specifically 24 h, 48 h, 72 h, 96 h, 120 h, or the like, or certainly may be another value within the foregoing range. This is not limited herein.

In an optional technical solution of this application, an addition amount of the cross-linking agent is 0.02 wt% to 0.2 wt% of the total mass of the monomers; and may be specifically 0.02 wt%, 0.025 wt%, 0.03 wt%, 0.035 wt%, 0.04 wt%, 0.05 wt%, 0.08 wt%, 0.1 wt%, 0.15 wt%, 0.2 wt%, or the like, or certainly may be another value within the foregoing range. This is not limited herein. Preferably, the addition amount of the cross-linking agent is 0.02 wt% to 0.06 wt% of the total mass of the monomers.

Control parameters of the cross-linking reaction are controlled, to help form a uniform and stable cross-linking product and improve the adhesion strength of the adhesive film.

In a specific embodiment, the alkyl acrylate soft monomer is 2-ethylhexyl acrylate and butyl acrylate, and the acrylate polar monomer is hydroxybutyl acrylate.

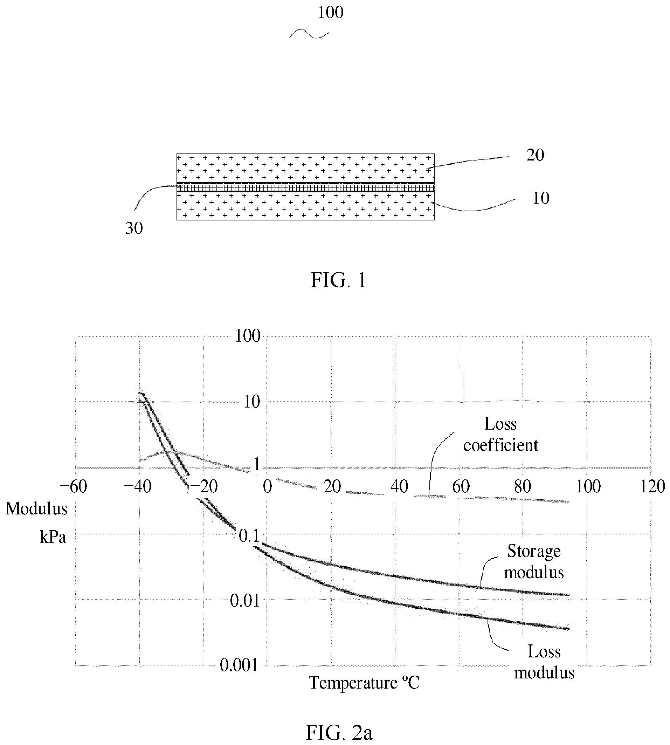

According to a third aspect, this application further provides a composite assembly 100. As shown in FIG. 1, the composite assembly 100 includes a first assembly 10, a second assembly 20, and an adhesive film 30 located between the first assembly 10 and the second assembly 20. The adhesive film 30 includes the adhesive film according to the first aspect or the adhesive film prepared by using the preparation method according to the second aspect.

In an optional technical solution of this application, in a temperature range of 25°C, at a frequency of 1 Hz, a shear storage modulus of the adhesive film is less than or equal to 35 kPa; and may be specifically 35 kPa, 32 kPa, 30 kPa, 28 kPa, 25 kPa, 22 kPa, 20 kPa, or the like, or certainly may be another value within the foregoing range. This is not limited herein. An excessively large shear storage modulus of the adhesive film at a room temperature causes an increase of a bending stress, and causes the composite assembly to be prone to damage during bending.

In an optional technical solution of this application, in a temperature range of -20°C, at a frequency of 1 Hz, a shear storage modulus of the adhesive film is less than or equal to 200 kPa; and may be specifically 200 kPa, 190 kPa, 180 kPa, 170 kPa, 160 kPa, 150 kPa, 140 kPa, 130 kPa, 100 kPa, or the like, or certainly may be another value within the foregoing range. This is not limited herein. An excessively large shear storage modulus of the adhesive film at a low temperature causes the composite assembly to be fractured or peeled at the low temperature during bending.

In an optional technical solution of this application, a glass-transition temperature of the adhesive film is less than or equal to -35°C; and may be specifically -35°C, -37°C, -38°C, -40°C, -42°C, -45°C, -50°C, or the like, or certainly may be another value within the foregoing range. This is not limited herein. An excessively high glass-transition temperature of the adhesive film causes an increase of a modulus at a low temperature for an optical adhesive, and causes the composite assembly to be fractured or peeled at the low temperature during bending.

In an optional technical solution of this application, after a shear stress of 20 kPa is applied for 10 min, recovery is performed for 10 min, and a creep recovery rate of the adhesive film is greater than or equal to 90%. The creep recovery rate may be specifically 90%, 92%, 94%, 95%, 96%, 97%, 98%, or the like, or certainly may be another value within the foregoing range. This is not limited herein. If the creep recovery rate of the adhesive film is excessively low, the composite assembly is prone to dislocation and damage during repeated folding processes. When the creep recovery rate of the adhesive film prepared in this application may be more than 92%, the adhesive film can be quickly recovered after a large quantity of folding tests, to avoid damage between assemblies connected by using the adhesive film.

An adhesion strength between the adhesive film and the first assembly or the second assembly is greater than or equal to 1200 g/inch. The adhesion strength may be specifically 1200 g/inch, 1250 g/inch, 1280 g/inch, 1300 g/inch, 1350 g/inch, 1400 g/inch, 1500 g/inch, or the like, or certainly may be another value within the foregoing range. This is not limited herein.

In an optional technical solution of this application, a thickness of the adhesive film ranges from 15 µm to 100 µm; and may be specifically 15 µm, 20 µm, 30 µm, 45 µm, 50 µm, 60 µm, 70 µm, 80 µm, 100 µm, or the like, or certainly may be another value within the foregoing range. This is not limited herein.

In a specific embodiment, the adhesive film may be used for interface bonding of a polyimide (CPI for short) film, a polyethylene glycol terephthalate (PET for short) film, a polymethyl methacrylate (PMMA for short) film, a tri-acetate cellulose film (TAC for short), a hard film, a polycarbonate (PC for short) film, ultra-thin glass, a stainless steel part, a titanium alloy part, an aluminum alloy part, a carbon fiber workpiece, a bamboo fiber workpiece, a sheet metal part, or the like.

According to a fourth aspect, this application provides an electronic device. The electronic device includes the composite assembly.

The electronic device may be a portable electronic device including other functions such as functions of a personal digital assistant and/or a music player, for example, a mobile phone, a tablet computer, or a wearable device (for example, a smartwatch) having a wireless communication function.

In some embodiments, the electronic device includes a curved display or a foldable display. The curved display is a display using flexible plastics. In comparison with a flat display, the curved display has better elasticity and is not easy to break. The curved display uses nonrigid glass as a substrate, and has better elasticity and is not easy to break. Therefore, a wear probability of a screen is reduced, especially, a mobile phone screen at a relatively high to-be-touched rate. The foldable display is a display that can be bent.

Because the foldable display needs to be folded repeatedly, the adhesive film needs to achieve a balance in terms of an adhesion strength, a creep recovery rate, and a modulus at a low temperature, to improve a service life of the foldable display.

Specifically, the electronic device includes a composite assembly. The composite assembly may be a foldable display assembly, a rotating shaft assembly, a middle-frame assembly, or the like. The adhesive film provided in this application has an excellent low modulus at a low temperature and a high creep recovery rate, and can adapt to a folding use scenario.

The following describes preparation of the adhesive film by using the adhesive film as an example and with reference to specific embodiments. A person skilled in the art understands that the preparation method described below is merely an example and does not limit this solution.

### 1. Preparation of the adhesive film

Under protection of nitrogen gas, an alkyl acrylate soft monomer, an acrylate polar monomer, and ethyl acetate are mixed, a thermal initiator (azobisisobutyronitrile, AIBN) is added, and heating is performed for a polymerization reaction in a range from 60°C to 80°C for 8 h to 20 h to obtain a prepolymer.

Coating is performed by using a mixture of the prepolymer and a cross-linking agent on a heavy release film by using a high-precision coating device, to form an adhesive coating. A thickness of the adhesive film is controlled to be 25 µm to 50 µm. Then, covering is performed on a light film, and rolling-up is performed to obtain an adhesive film roll.

For adhesive films prepared according to the foregoing method in Example 1 to Example 19 (that is, S1 to S19 in the table) and an adhesive in Comparative example 1 (that is, R1 in the table), parameters of a preparation process are shown in Table 1.

**Table 1**

| Sample | Alkyl acrylate soft monomer | | Acrylate polar monomer | | Thermal initiator | Weight-average molecular weight of the prepolymer (Da) | Cross-linking agent |
|---|---|---|---|---|---|---|---|
| S1 | 2EHA, 60 g | BA, 29.5 g | 4HBA, 10g | AA, 0.5 g | AIBN, 0.03 g | 800000 | TDI, 0.03 g |
| S2 | 2EHA, 60 g | BA, 20 g | 4HBA, 19.5 g | AA, 0.5 g | AIBN, 0.03 g | 1000000 | TDI, 0.03 g |
| S3 | 2EHA, 62 g | BA, 23 g | 4HBA, 15 g | / | AIBN, 0.03 g | 1200000 | HDI, 0.03 g |
| S4 | 2EHA, 67 g | BA, 23 g | 4HBA, 10g | / | AIBN, 0.03 g | 1200000 | HDI, 0.03 g |
| S5 | 2EHA, 70 g | BA, 10 g | 4HBA, 20 g | / | AIBN, 0.03 g | 1200000 | HDI, 0.03 g |
| S6 | 2EHA, 70 g | BA, 10 g | / | 2HEA, 20 g | AIBN, 0.03 g | 900000 | HDI, 0.03 g |
| S7 | 2EHA, 80 g | / | 4HBA, 20 g | / | AIBN, 0.025 g | 1100000 | HDI, 0.03 g |
| S8 | 2EHA, 80 g | / | 4HBA, 15g | 2HEA, 5 g | AIBN, 0.03 g | 1100000 | TDI, 0.05 g |
| S9 | 2EHA, 80 g | / | 4HBA, 10g | 2HEA, 10 g | AIBN, 0.03 g | 1200000 | TDI, 0.05 g |
| S10 | 2EHA, 80 g | / | / | 2HEA, 20 g | AIBN, 0.03 g | 1200000 | TDI, 0.05 g |
| S11 | 2EHA, 80 g | BA, 10 g | 4HBA, 10g | / | AIBN, 0.05 g | 1200000 | HDI, 0.05 g |
| S12 | 2EHA, 80 g | / | / | 2HEA, 20 g | AIBN, 0.03 g | 900000 | HDI, 0.03 g |
| S13 | 2EHA, 85 g | / | 4HBA, 15 g | / | AIBN, 0.05 g | 910000 | HDI, 0.05 g |
| S14 | 2EHA, 85 g | / | 4HBA, 15 g | / | AIBN, 0.06 g | 910000 | HDI, 0.06 g |
| S15 | 2EHMA, 70 g | BA, 10 g | 4HBA, 20 g | / | AIBN, 0.03 g | 762000 | HDI, 0.03 g |
| S16 | 2EHA, 40 g; 2EHMA, 30 g | BA, 10 g | 4HBA, 20 g | / | AIBN, 0.03 g | 812000 | HDI, 0.03 g |
| S17 | EA, 70 g | BA, 10 g | 4HBA, 20 g | / | AIBN, 0.03 g | 651000 | HDI, 0.03 g |
| S18 | 2EHA, 40 g EA, 30 g | BA, 10 g | 4HBA, 20 g | / | AIBN, 0.03 g | 715000 | HDI, 0.03 g |
| S19 | 2EHA, 66 g | BA, 30 g | 4HBA, 3.5 g | AA, 0.5 g | AIBN, 0.03 g | 800000 | HDI, 0.03 g |
| R1 | 2EHA, 80 g | / | 4HBA, 20 g | / | / | 1000000 | HDI, 0.025 g |

The slash (/) in the table indicates no addition.

### 2. Performance test

### Preparation of a test sample:

1. The adhesive film was cut into small pieces. The light release film was removed. Two pieces of the adhesive film from which the light release film was removed were attached in a 2 kg rolling manner. Then, the heavy release film was removed. The foregoing operations were repeated, to finally stack the adhesive films to about 0.5 mm to 1 mm.
2. The stacked adhesive films were pressed by a press-fitting device. A temperature of the device was set to 80°C, and a press-fitting thickness is set to 0.5-1 mm. After press-fitting was performed for 20 minutes, a sample was taken out, and then the prepared stacked adhesive films were cut into round sheets with a diameter of 8 mm by using a device.

### (1) Rheological property test of the adhesive film

Test device: rotational rheometer.
Sample quantity: five adhesive film samples with a diameter of 8 mm.

### Test steps:

A release film is removed from the prepared samples. The samples are attached to a test position of the rheometer.

Corresponding settings are performed according to normal test steps of the rheometer. Setting conditions are as follows: A temperature ranges from -40°C to +100°C; a temperature rise speed is 1°C/min; a strain is 1%; a frequency is 1 Hz; and a Z-direction pressure is 0.1 N.

An original graph is saved. Storage moduli G' at -40°C, -20°C, 25°C, and 60°C and a glass-transition temperature (Tg) corresponding to a peak value of tanδ are recorded.

### (2) Creep recovery rate rest of the adhesive film

Test device: rotational rheometer.

Sample quantity: five stacked-adhesive samples with a diameter of 8 mm.

### Test steps:

A release film is removed from the prepared samples. The samples are attached to a test position of the rheometer.

Corresponding settings are performed according to normal test steps of the rheometer. Setting conditions are as follows: A force of 20 kPa is applied for a duration of 600s. The external force is withdrawn. An adhesive film recovery curve is tested for a duration of 600s. A Z-direction pressure is 0.1 N. A deformation and a recovery curve of the adhesive film are recorded in a test process.

An original graph is saved. A maximum deformation and a final recovery value are recorded. A creep recovery rate is calculated.

The foregoing performance test is performed for the prepared Example 1 to Example 19 (that is, S1 to S19 in the table) and the Comparative example 1 (that is, R1 in the table). Test results are shown in Table 2.

**Table 2**

| Sample | Glass-transition temperature (°C) of the adhesive film | Adhesion strength (g/inch) to a surface of a steel plate | Creep recovery rate (%) at a room temperature | -40°C storage modulus (kPa) | -20°C storage modulus (kPa) | 25°C storage modulus (kPa) | 60°C storage modulus (kPa) | 200000 times of dynamic bending |
|---|---|---|---|---|---|---|---|---|
| S1 | -35 | 1378 | 93.20 | 604 | 204.2 | 28.1 | 15.25 | Qualified |
| S2 | -30 | 1357 | 95.50 | 10460 | 309.28 | 30.02 | 16.51 | Qualified |
| S3 | -37 | 1135 | 93.00 | 1981.3 | 113.46 | 22.29 | 15.145 | Qualified |
| S4 | -36 | 1054 | 93.00 | 3265 | 152.91 | 31.56 | 21.556 | Qualified |
| S5 | -34 | 1277 | 93.00 | 7820 | 206.32 | 35.6 | 20.14 | Qualified |
| S6 | -35 | 1715 | 91 | 19696 | 561.23 | 51.7 | 28.1 | Qualified |
| S7 | -37 | 1328 | 93.60 | 3377 | 146.76 | 19.56 | 10.68 | Qualified |
| S8 | -38 | 1307.5 | 75 | 12680 | 282.81 | 31.23 | 17.38 | Qualified |
| S9 | -39 | 1483 | 89.30 | 3377 | 146.76 | 19.56 | 10.68 | Qualified |
| S10 | -33 | 1607.5 | 93.20 | 4500 | 175.21 | 31.23 | 20.12 | Qualified |
| S11 | -38 | 1377 | 92.00 | 7271.35 | 122.89 | 45.77 | 34.53 | Qualified |
| S12 | -32 | 741.5 | 83.22 | 6532 | 123.5 | 32.2 | 18.9 | Qualified |
| S13 | -38 | 1000 | 67 | 19554 | 164 | 23.8 | 10.8 | Qualified |
| S14 | -37.5 | 825 | 75 | 20543 | 166 | 26.3 | 13.1 | Qualified |
| S15 | -23.1 | 1028 | 82.17 | 96524 | 381 | 23.5 | 16.2 | Qualified |
| S16 | -26.3 | 985 | 83.55 | 65891 | 428 | 24.8 | 13.4 | Qualified |
| S17 | -18.3 | 659 | 85.9 | 182569 | 196 | 26.1 | 14.8 | Qualified |
| S18 | -22.5 | 903 | 83.7 | 126549 | 265 | 25.7 | 12.2 | Qualified |
| S19 | -42 | 1104 | 92.5 | 719.31 | 87.33 | 18.97 | 11.4 | Unqualified |
| R1 | -40 | 1070 | 87.6 | 2018 | 136 | 40 | 23.79 | Qualified |

It can be learned from the test data in Example 1 to Example 18 in Table 1 and Table 2 that, when the alkyl acrylate soft monomer and the acrylate polar monomer in the adhesive film are controlled within an appropriate mass ratio range, the adhesive film can have better wetting effect, an interface adhesion strength of the adhesive film can be improved, and the adhesive film has an excellent low modulus at a low temperature and a high creep recovery rate. Therefore, in a foldable electronic device using the adhesive film, the adhesive film can implement creep recovery with dislocation of film materials in repeated folding processes, to avoid a case in which film materials cannot be dislocated due to an excessively large adhesion strength of the adhesive film, thereby improving a service life of the foldable electronic device.

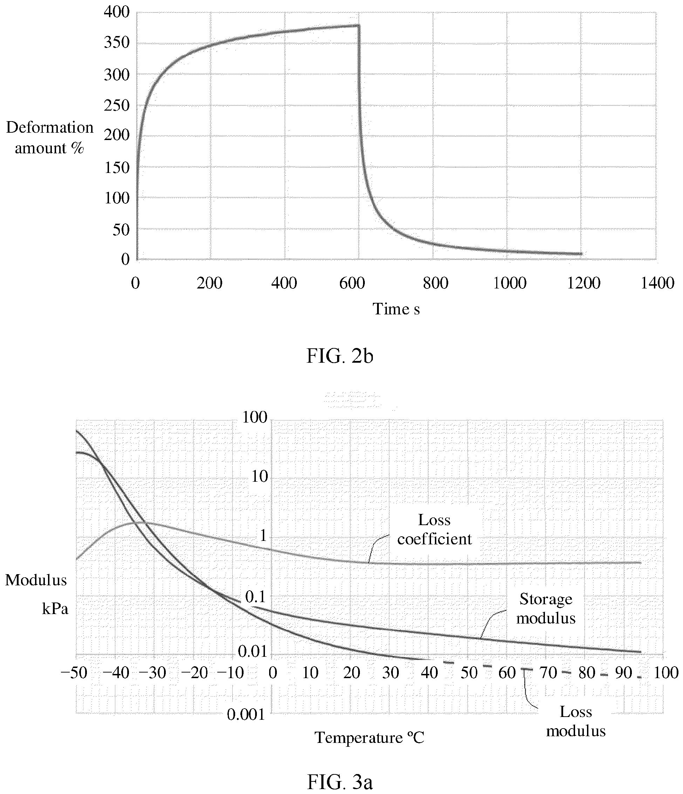

FIG. 2a is a diagram of rheological test curves of an adhesive film prepared in Example 2. FIG. 2b is a diagram of a creep recovery rate curve of an adhesive film prepared in Example 2. It can be learned from FIG. 2a and FIG. 2b that, in comparison with Example 3, an acrylate polar monomer (AA) is added in a prepolymer of the adhesive film in Example 2, to improve polarity of the prepolymer of the adhesive film, that is, improve an interface adhesion strength of the adhesive film. It can be learned that by adding the acrylate polar monomer, the adhesion strength of the adhesive film can be improved, and a creep recovery rate of the adhesive film can be further improved.

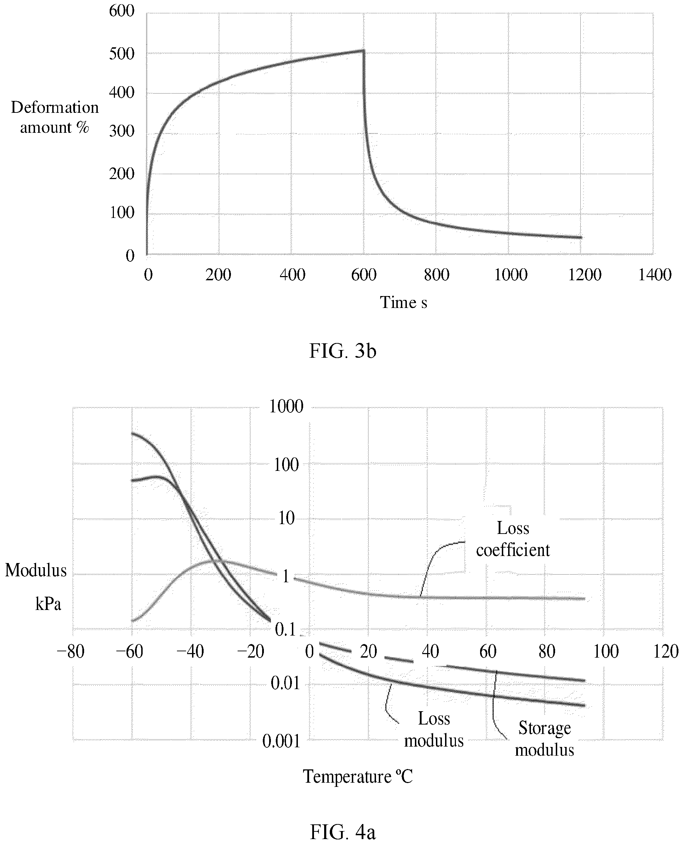

FIG. 3a is a diagram of rheological test curves of an adhesive film prepared in Example 5. FIG. 3b is a diagram of a creep recovery rate curve of an adhesive film prepared in Example 5. With reference to FIG. 3a and FIG. 3b, in Example 5, a prepolymer includes 70 g of 2-ethylhexyl acrylate, 10 g of butyl acrylate, and 20 g of hydroxybutyl acrylate. In comparison with Comparative example 1 in which butyl acrylate (BA) is not added, a creep recovery rate in Example 5 is higher than that in Comparative example 1. Therefore, it can be learned that by adding butyl acrylate, wettability of the adhesive film can be adjusted, a creep recovery rate of the adhesive film can be improved, and an interface adhesion strength can be improved.

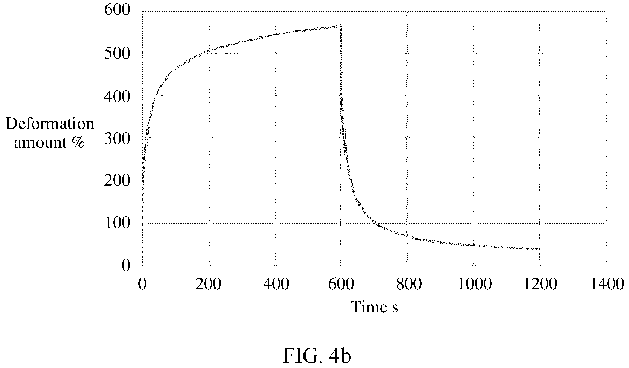

FIG. 4a is a diagram of rheological test curves of an adhesive film prepared in Example 7. FIG. 4b is a diagram of a creep recovery rate curve of an adhesive film prepared in Example 7. A prepolymer of the adhesive film in Example 7 includes 80 g of 2-ethylhexyl acrylate and 20 g of hydroxybutyl acrylate, so that the adhesive film has an excellent creep recovery rate and an excellent adhesion strength.

It can be learned based on the test data in Examples 1, 2, 3, and 5 that when a used cross-linking agent is a TDI cross-linking agent, the adhesive film can present a better creep recovery rate.

It can be learned based on the test data in Examples 5, 15, and 16 that recovery performance of various adhesive films prepared by using 2-ethylhexyl acrylate and different types of alkyl acrylate soft monomers is slightly different. This is because another monomer has a large steric hindrance, and creep recovery performance of a finished product of the adhesive film is poor. Preferably, the adhesive film prepared by using 2-ethylhexyl acrylate and hydroxybutyl acrylate has the best creep recovery performance.

It can be learned based on the test data in Examples 5, 17, and 18 that different alkyl acrylate soft monomers can cooperate with the acrylate polar monomer to adjust wettability of the adhesive film.

It can be learned based on the test data in Examples 5 and 19 that an added polar monomer in Example 19 is excessively small and is only 4 g, a storage modulus at a normal temperature and a storage modulus at a high temperature are both relatively poor, an adhesion strength is small, and a fracture occurs after dynamic bending is performed for 200000 times. Preferably, the mass fraction of the acrylate polar monomer in the prepolymer ranges from 10 wt% to 25 wt%.

Although this application is disclosed above with reference to preferred embodiments, they are not intended to limit the claims. Any person skilled in the art can make several possible changes and modifications without departing from the concept of this application. Therefore, the protection scope of this application shall be subject to the scope defined by the claims of this application.

## Claims

1. An adhesive film, wherein the adhesive film is prepared through a cross-linking reaction of a prepolymer, the prepolymer comprises an alkyl acrylate soft monomer and an acrylate polar monomer, a mass fraction of the alkyl acrylate soft monomer in the prepolymer is greater than or equal to 60 wt%, and a mass fraction of the acrylate polar monomer in the prepolymer is less than 30 wt%.

2. The adhesive film according to claim 1, wherein the prepolymer comprises an alkyl acrylate soft monomer shown in Formula (I): 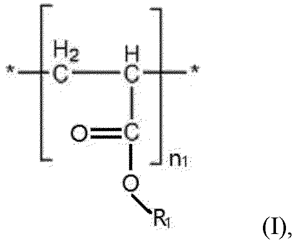 wherein
R₁ is independently selected from substituted or unsubstituted C1-C20 alkyl groups, and n₁ is an integer greater than 0.

3. The adhesive film according to claim 1, wherein the prepolymer comprises an acrylate polar monomer shown in Formula (II) and/or an acrylate polar monomer shown in Formula (III): 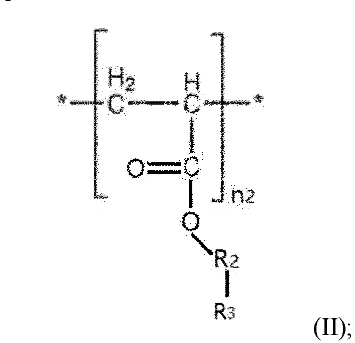 and 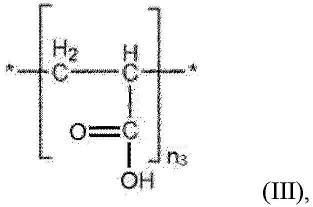 wherein
R₂ is independently selected from substituted or unsubstituted C1-C10 alkyl groups, R₃ is selected from at least one of a hydroxyl group, a carboxyl group, an epoxy group, and an amino group, and n₂ and n₃ are integers greater than 0.

4. The adhesive film according to claim 1, wherein the mass fraction of the alkyl acrylate soft monomer in the prepolymer ranges from 60 wt% to 85 wt%, and the mass fraction of the acrylate polar monomer in the prepolymer ranges from 10 wt% to 25 wt%.

5. The adhesive film according to claim 1, wherein the prepolymer comprises two types of alkyl acrylate soft monomers, one type of alkyl acrylate soft monomer is selected from butyl acrylate, and a mass fraction of the butyl acrylate in the prepolymer ranges from 5 wt% to 20 wt%.

6. The adhesive film according to claim 1, wherein a weight-average molecular weight of the prepolymer is greater than or equal to 600000 Da.

7. A preparation method of an adhesive film, wherein the method comprises:
under protection of an inert gas, mixing an alkyl acrylate soft monomer, an acrylate polar monomer, and a solvent, adding a thermal initiator, and performing heating for a polymerization reaction to obtain a prepolymer, wherein a mass fraction of the alkyl acrylate soft monomer in the prepolymer is greater than or equal to 60 wt%, and a mass fraction of the acrylate polar monomer in the prepolymer is less than 30 wt%; and
performing coating by using a mixture of the prepolymer and a cross-linking agent to form an adhesive coating, and performing heating for a cross-linking reaction to obtain an adhesive film.

8. The preparation method according to claim 7, wherein a weight-average molecular weight of the prepolymer is greater than or equal to 600000 Da.

9. The preparation method according to claim 7, wherein the prepolymer comprises an alkyl acrylate soft monomer shown in Formula (I): 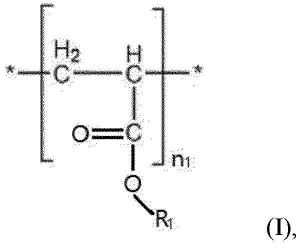 wherein
R₁ is independently selected from substituted or unsubstituted C1-C20 alkyl groups, and n₁ is an integer greater than 0.

10. The preparation method according to claim 7, wherein the prepolymer comprises an acrylate polar monomer shown in Formula (II) and/or an acrylate polar monomer shown in Formula (III): 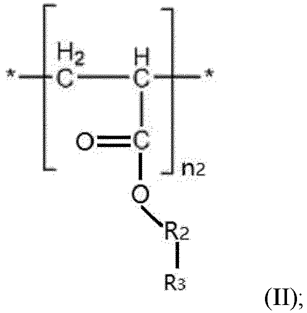 and 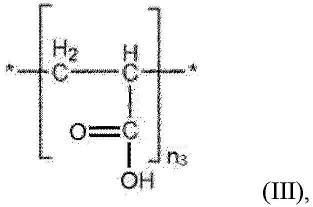 wherein
R₂ is independently selected from substituted or unsubstituted C1-C10 alkyl groups, R₃ is selected from at least one of a hydroxyl group, a carboxyl group, an epoxy group, and an amino group, and n₂ and n₃ are integers greater than 0.

11. The preparation method according to claim 7, wherein the mass fraction of the alkyl acrylate soft monomer in the prepolymer ranges from 60 wt% to 85 wt%, and the mass fraction of the acrylate polar monomer in the prepolymer ranges from 10 wt% to 25 wt%.

12. The preparation method according to claim 7, wherein the prepolymer comprises two types of alkyl acrylate soft monomers, one type of alkyl acrylate soft monomer is selected from butyl acrylate, and a mass fraction of the butyl acrylate in the prepolymer ranges from 5 wt% to 20 wt%.

13. The preparation method according to claim 7, wherein the preparation method meets at least one of the following features:
(1) the thermal initiator is selected from at least one of azobisisobutyronitrile, azobisisoheptonitrile, dimethyl 2,2'-azobis(2-methylpropionate), 2-(1-cyano-1-methylethyl)azocarboxamide, dibenzoyl peroxide, tert-butyl peroxybenzoate, tert-pentyl peroxybenzoate, dicumyl peroxide, and hydrogen peroxide;
(2) a heating temperature of the polymerization reaction ranges from 60°C to 80°C;
(3) a time of the polymerization reaction ranges from 8 h to 20 h;
(4) the inert gas comprises at least one of nitrogen, helium, neon, and krypton;
(5) an addition amount of the thermal initiator is 0.02 wt% to 0.5 wt% of a total mass of the monomers;
(6) the cross-linking agent is selected from at least one of toluene diisocyanate, hexamethylene diisocyanate, isophorone diisocyanate, and an epoxy cross-linking agent; and
(7) an addition amount of the cross-linking agent is 0.02 wt% to 0.2 wt% of the total mass of the monomers.

14. A composite assembly, wherein the composite assembly comprises a first assembly, a second assembly, and an adhesive film located between the first assembly and the second assembly, and the adhesive film comprises the adhesive film according to any one of claims 1 to 6 or the adhesive film prepared according to the preparation method according to any one of claims 7 to 13.

15. The composite assembly according to claim 14, wherein the composite assembly meets at least one of the following features:
(1) in a temperature range of 25°C, at a frequency of 1 Hz, a shear storage modulus of the adhesive film is less than or equal to 35 kPa;
(2) in a temperature range of -20°C, at a frequency of 1 Hz, the shear storage modulus of the adhesive film is less than or equal to 200 kPa;
(3) after a shear stress of 20 kPa is applied for 10 min, recovery is performed for 10 min, and a creep recovery rate of the adhesive film is greater than or equal to 90%;
(4) a glass-transition temperature of the adhesive film is less than or equal to -35°C;
(5) an adhesion strength between the adhesive film and the first assembly or the second assembly is greater than or equal to 1200 g/inch; and
(6) a thickness of the adhesive film ranges from 15 µm to 200 µm.

16. An electronic device, wherein the electronic device comprises the composite assembly according to claim 14 or 15.

17. A foldable mobile phone, wherein the foldable mobile phone comprises the composite assembly according to claim 14 or 15.
